# DEMANDE DE BREVET EUROPEEN

(11) **EP 1 094 494 A1**
(43) Date de publication de la demande: **25.04.2001**
(21) Numéro de dépôt: 00420210.7
(22) Date de dépôt: 17.10.2000
(51) Int. Cl.: H01J 37/32

(54) **Procédé de production d'un plasma par décharges à barrière multipolaire de type capacitif, et dispositif pour la mise en oeuvre d'un tel procédé**

(30) Priorité: 19.10.1999 FR 9913305
(71) Demandeur: METAL PROCESS, Société à Responsabilité Limiteé:, 77144 Montevrain (FR)
(72) Inventeur: Lagarde, Thierry, 38450 Vif (FR); Pelletier, Jacques, 38400 Saint Martin d'Heres (FR)
(74) Mandataire: Thibault, Jean-Marc

(57) **Abrégé**

- L'invention concerne un dispositif de production d'un plasma par décharges de type capacitif, pour la mise en oeuvre du procédé, du type comprenant une électrode passive (**3**) placée à distance d'une électrode active (**4**) alimentée par une tension de maintien de décharge.
- Selon l'invention, le dispositif comporte, entre les électrodes active (**4**) et passive (**3**), une barrière magnétique multipolaire (**11**) dont les lignes de champ magnétique s'étendent de part et d'autre d'un plan de séparation (**P**) parallèle aux électrodes, de manière à assurer l'oscillation, entre les pôles, des électrons rapides issus de l'électrode active, en vue de créer des zones de production et de diffusion de plasma situées de part et d'autre de la barrière magnétique en relation de chaque électrode.

## Description

L'objet de l'invention concerne le domaine technique de la production par décharges de type capacitif, de plasmas à moyenne et basse pressions (de l'ordre de quelques 10⁻² à quelques 10 Pascal), présentant un caractère uniforme apte à être contrôlé, d'une part, sur de grandes surfaces planes ou non et, d'autre part, dans un large domaine depuis les hautes densités ioniques (jusqu'à 10¹² cm⁻³) jusqu'aux très faibles densités (10⁸ cm⁻³).

L'objet de l'invention trouve des applications particulièrement avantageuses dans tous les domaines nécessitant la production, sur de grandes surfaces, de plasmas uniformes à moyenne ou basse tension, le traitement de surfaces (nettoyage, gravure, dépôt) et, en particulier, le dépôt de polymères plasma, ou un contrôle indépendant de l'énergie de bombardement ionique d'une surface ou substrat.

D'une manière classique, un dispositif de production d'un plasma par décharges de type capacitif, comporte une électrode passive placée à distance d'une électrode active. Les électrodes sont montées à l'intérieur d'une enceinte contenant une pression de gaz sensiblement constante. L'électrode passive est placée à un potentiel électrique, par exemple de référence, tel que la masse, tandis que l'électrode active est alimentée par une tension de maintien de décharge. La tension électrique appliquée à l'électrode active est soit une tension continue négative par rapport à l'électrode passive, soit une tension alternative basse fréquence ou le plus souvent, radiofréquence (13,56 MHz ou un multiple ou sous-multiple de 13,56 MHz) appliquée à travers une capacité de faible impédance. Au-dessus d'une valeur de tension appliquée (qui dépend de la nature du gaz, de sa pression, de la distance inter-électrode, de la fréquence du signal appliqué et de la nature des électrodes et de leurs dimensions relatives), une décharge s'allume entre les deux électrodes.

Quelle que soit la fréquence de la tension appliquée, l'une des électrodes est toujours polarisée négativement par rapport à l'autre. Comme le potentiel du plasma s'ajuste généralement à une valeur légèrement positive par rapport à l'électrode la plus positive, l'électrode la plus négative subit donc un bombardement intense par les ions positifs du plasma accélérés depuis le plasma, vers l'électrode la plus négative, à travers la gaine ionique séparant le plasma de l'électrode. Pendant ce temps, l'électrode la plus positive ne subit qu'un bombardement ionique de très faible énergie, dans la mesure où son potentiel est alors très proche de celui du potentiel plasma.

Lorsque les ions viennent frapper l'électrode la plus négative par rapport au potentiel plasma, ils émettent généralement des électrons secondaires qui sont eux accélérés en sens inverse vers le plasma. En traversant l'espace inter-électrode, ces électrons secondaires, dits rapides, produisent le plasma, c'est-à-dire produisent des électrons lents ou thermiques et des ions. Si le libre parcours moyens des électrons rapides est plus grand que la distance inter-électrode (cas des faible et moyenne pressions), la plupart des électrons rapides émis par l'électrode négative ne subissant que peu de collisions inélastiques, ne sont pas ralentis et sont donc collectés par l'électrode positive. Par contre, si le libre parcours moyens des électrons rapides est plus court que la distance inter-électrode (cas des pressions plus élevées), les électrons rapides sont ralentis par les processus collisionnels inélastiques et peuvent devenir à leur tour, des électrons lents. En régime permanent, les ions et les électrons lents produits au sein du plasma, se perdent sur les parois en quantité égale, condition au maintien de la neutralité macroscopique du plasma.

En dehors des électrons rapides émis par le bombardement de l'électrode négative de la décharge, certains électrons peuvent être aussi accélérés très efficacement par le champ électrique périodique au sein de la gaine ionique. En effet, lorsque la tension de l'électrode devient plus négative par rapport au potentiel du plasma, la gaine ionique s'élargit et les électrons présents sont alors repoussés et accélérés vers le plasma par le champ électrique se développant au sein de la gaine. Naturellement, les ions présents dans la gaine sont accélérés en sens inverse par l'électrode. En fait, cette dynamique de gaine peut contribuer de façon significative, à la production d'électrons rapides et donc à la production de plasma.

Un inconvénient d'une décharge capacitive est que, pour une configuration géométrique de la décharge donnée, les conditions d'allumage ou de claquage et surtout de maintien de la décharge, nécessitent l'application d'une tension de seuil entre les électrodes, c'est-à-dire d'une puissance de seuil de maintien à la décharge. Il en résulte une limitation des possibilités de production de plasma vers les faibles densités. En d'autres termes, alors que l'augmentation de la densité du plasma peut être obtenue par la simple augmentation de la puissance injectée dans la décharge, la diminution de la densité vers les plus basses valeurs n'est pas possible.

Comme expliqué ci-dessus, le fonctionnement d'une décharge capacitive est déterminé par :
- la configuration de la décharge (distance inter-électrode et le rapport des surfaces des électrodes,
- la nature du gaz (section efficace de collision),
- la pression du gaz (fréquences de collision et libres parcours moyens),
- la nature des électrodes (taux d'émission des électrons secondaires),
- la fréquence de la tension appliquée (dynamique de gaine, énergie de bombardement ionique),
- et la puissance électrique injectée dans le plasma.

Les paramètres ci-dessus définissent totalement les conditions de la décharge, c'est-à-dire son point de fonctionnement. Ces paramètres gouvernent en même temps, les paramètres d'interaction plasma - surface qui sont totalement dépendants du point de fonctionnement de la décharge capacitive. Il ne peut donc y avoir indépendance entre la production du plasma et l'interaction du plasma avec la surface à traiter disposée sur l'une des électrodes. Autrement dit, il n'est pas possible de régler l'énergie de bombardement ionique sans modifier la puissance délivrée à la décharge et donc les caractéristiques électriques de la décharge (densité, température électronique, etc).

Une possibilité généralement utilisée pour remédier à cet inconvénient est d'ajouter une ou plusieurs électrodes polarisées, afin de modifier le bilan de courant sur les électrodes. Toutefois, l'obtention par cette méthode de degrés de liberté supplémentaires pour les paramètres plasma est largement annihilée par la complexité de la situation ainsi créée.

L'objet de l'invention vise donc à remédier aux inconvénients ci-dessus en proposant un procédé de production d'un plasma par décharges de type capacitif, produites entre une électrode active et une électrode passive, l'électrode passive étant placée à un potentiel électrique donné, par exemple de référence, tandis que l'électrode active est alimentée par une tension de maintien de décharge.

Pour atteindre un tel objectif, le procédé selon l'invention consiste à placer entre les électrodes, une barrière magnétique multipolaire dont les lignes de champ magnétique s'étendent de part et d'autre d'un plan de séparation parallèle aux électrodes, de manière à assurer l'oscillation, entre les pôles, des électrons rapides accélérés par l'électrode active, en vue de créer des zones de production et de diffusion de plasma situées de part et d'autre de la barrière magnétique en relation de chaque électrode.

Un autre inconvénient inhérent aux décharges capacitives est l'existence d'une forte non uniformité de la densité du plasma due, en particulier, aux effets de bord qui peuvent s'avérer très importants. Le seul moyen connu utilisé pour remédier à ce défaut est d'ajuster ou de répartir l'injection des gaz, de façon à corriger la non uniformité du procédé mis en oeuvre.

Un autre objet de l'invention vise à proposer un procédé de production d'un plasma par décharges de type capacitif, adapté pour obtenir un claquage des décharges capacitives à de très faibles ou très élevés niveaux de puissance par unité de surface, tout en obtenant un plasma uniforme sur des grandes surfaces.

Pour atteindre un tel objectif, le procédé selon l'invention consiste :
- à réaliser l'électrode active par une série d'électrodes actives élémentaires délimitant chacune en regard de l'électrode passive, d'une part, une surface active et, d'autre part, une surface passive,
- à répartir les électrodes actives élémentaires de façon géométriquement uniforme en regard de l'électrode passive, en vue d'obtenir un plasma uniforme,
- et à alimenter les surfaces actives des électrodes actives élémentaires par une tension de maintien de décharge.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

Les **fig. 1A** et **1B** sont des vues schématiques, montrant deux formes d'exemples de réalisation d'un dispositif de production mettant en oeuvre une caractéristique avantageuse de l'invention.

Les **fig. 2A** et **2B** sont des vues schématiques de face et de profil d'un autre exemple de réalisation d'un dispositif de production conforme à l'invention.

Les **fig. 3A** et **3B** sont des vues schématiques de face et de profil d'un autre exemple de réalisation d'un dispositif de production conforme à l'invention.

La **fig. 4** est un exemple de réalisation d'un dispositif de production conforme à l'invention mettant en oeuvre une autre caractéristique avantageuse.

Les **fig. 5** et **6** illustrent diverses formes de réalisation géométriques d'un dispositif de production conforme à l'exemple illustré à la **fig. 4**.

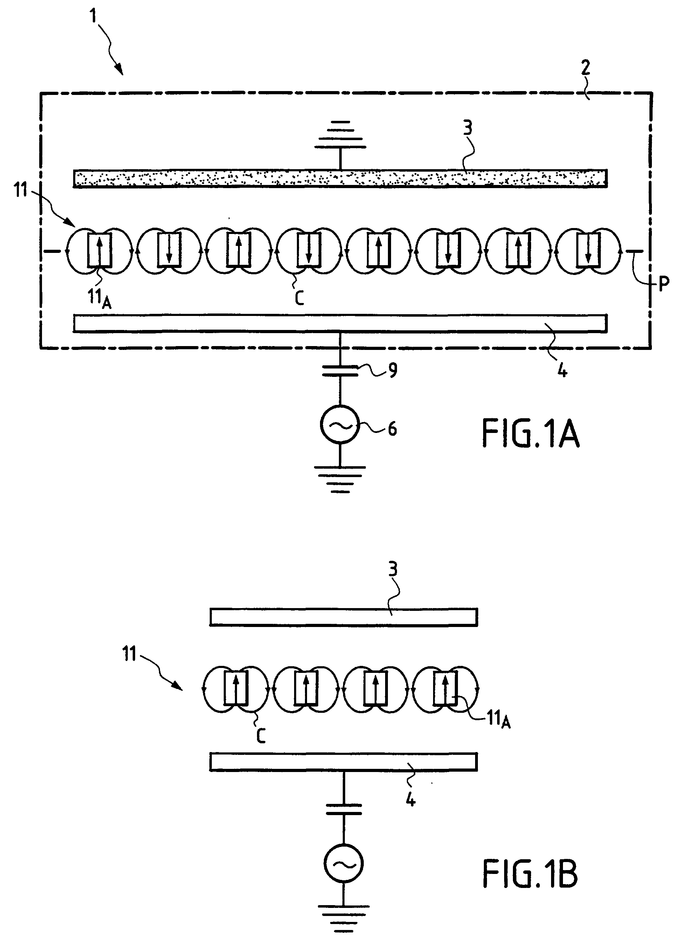

La **fig. 1A** illustre, à titre d'exemple, un dispositif **1** de production d'un plasma à l'intérieur d'une enceinte étanche **2** représentée à titre schématique. Une telle enceinte **2** est équipée classiquement de dispositifs d'introduction de gaz et de pompage de gaz non représentés mais connus en soi permettant de maintenir la pression du gaz à ioniser à une valeur souhaitée qui peut être, par exemple, de l'ordre de 10⁻² à quelques 10 Pascal suivant la nature du gaz, la puissance injectée, la nature des électrodes,etc.

Le dispositif de production **1** comporte, dans l'enceinte **2**, une électrode dite passive **3**, placée à un potentiel électrique donné, par exemple de référence, tel que la masse dans l'exemple illustré. L'électrode passive **3** est montée à distance d'une électrode active **4** alimentée par une source **6** de production d'une tension de maintien d'une décharge. La source de production **6** est soit une source de production continue négative, soit, comme illustré, une source de production d'une tension alternative basse fréquence ou radiofréquence appliquée à travers un condensateur **9**.

Conformément à l'invention, le dispositif de production de plasmas **1** comporte une barrière magnétique multipolaire **11** dont les lignes de champ magnétique **C** s'étendent de part et d'autre d'un plan **P** de séparation sensiblement parallèle aux plans d'extensions des électrodes **3, 4**. Cette barrière magnétique **11** assure l'oscillation entre les pôles magnétiques des électrons rapides issus de l'électrode active **4**, en vue de créer des zones de production et de diffusion de plasma situées de part et d'autre de la barrière magnétique **11** en relation de chaque électrode **3, 4**. Dans l'exemple illustré a la **fig. 1A**, cette barrière magnétique **11** est constituée par une série d'aimants permanents **11A**, constituant sur toute la surface utile de la décharge, un ensemble de pistes magnétiques ou structures magnétrons tridimensionnelles, dont les lignes de champ s'étendent de part et d'autre du plan de séparation **P** des électrodes **3, 4**. Les aimants sont placés à distance les uns des autres dans le plan **P** en ayant leurs axes d'aimantation perpendiculaires au plan **P**, alternativement opposés d'un aimant voisin à un autre (**fig. 1A**) ou orientés dans le même sens (**fig. 1B**). L'intérêt d'une structure magnétique multipolaire **11**, formée à partir d'un réseau d'aimants permanent à polarités magnétiques successives alternées, concerne la décroissance exponentielle de l'intensité du champ magnétique en s'éloignant des aimants. Ainsi, l'électrode active **4**, comme l'électrode passive **3**, peuvent facilement se situer en dehors de la zone de champ magnétique intense, c'est-à-dire dans une zone de champ magnétique résiduel. Dans une telle configuration de décharge, les électrons rapides, qui sont émis et accélérés par l'électrode active **4** et qui traversent l'espace entre l'électrode active **4** et la barrière magnétique multipolaire **11**, se retrouvent piégés en grand nombre dans le champ magnétique. Contrairement à ce qui se passe en l'absence de barrière magnétique, les électrons rapides ainsi piégés ne sont plus captés par l'électrode passive **3** et produisent donc du plasma le long de leur trajectoire dans le champ magnétique multipolaire. Par conséquent, à basse et moyenne pressions, l'énergie des électrons rapides n'est plus déposée sur les électrodes passives mais dissipée dans la production de plasma. Ainsi, pour une densité de plasma par unité de surface donnée, la densité de plasma produite est donc plus élevée et ce, de façon significative. De même, pour le claquage ou le maintien du plasma, la diminution des pertes en électrons rapides requiert un taux d'émission secondaire d'électrons plus faibles, c'est-à-dire une énergie de bombardement ionique plus faible, une tension de claquage ou de maintien plus faible, ou bien encore une densité de puissance par unité de surface plus faible.

Entre deux collisions, la trajectoire des électrons rapides piégés dans le champ magnétique multipolaire est essentiellement gouvernée par les forces magnétiques. Il apparaît ainsi que les trajectoires des électrons rapides s'enroulent autour des lignes de champ magnétique qui relient deux pôles magnétiques opposés et oscillent entre des points miroirs situés près de ces deux pôles magnétiques opposés. En outre, les électrons rapides dérivent lentement dans la direction perpendiculaire au champ magnétique et peuvent ainsi parcourir toute ou partie du circuit magnétique de la structure magnétron tridimensionnelle. Comme les lignes de champ magnétique s'étendent de part et d'autre de la barrière multipolaire (le plan de séparation P) et sont généralement symétriques de part et d'autre de chaque structure magnétron constituant la barrière multipolaire, les électrons rapides piégés dans le champ magnétique produisent, donc le long de leur trajectoire, autant de plasmas de chaque côté de la barrière multipolaire. Par conséquent, du côté de l'électrode passive **3**, il est obtenu un plasma dont les caractéristiques sont découplées de celles du plasma produit du côté de l'électrode active **4**.

Selon une caractéristique avantageuse de l'invention, il est alors possible de polariser l'électrode passive **3** par rapport au potentiel du plasma par application d'une tension de polarisation, par exemple périodique ou continue négative et ce indépendamment de la production de ce plasma. Il peut ainsi être obtenu un découplage entre la production de plasma et la polarisation de l'électrode passive **3** sur laquelle est placée par exemple une surface à traiter.

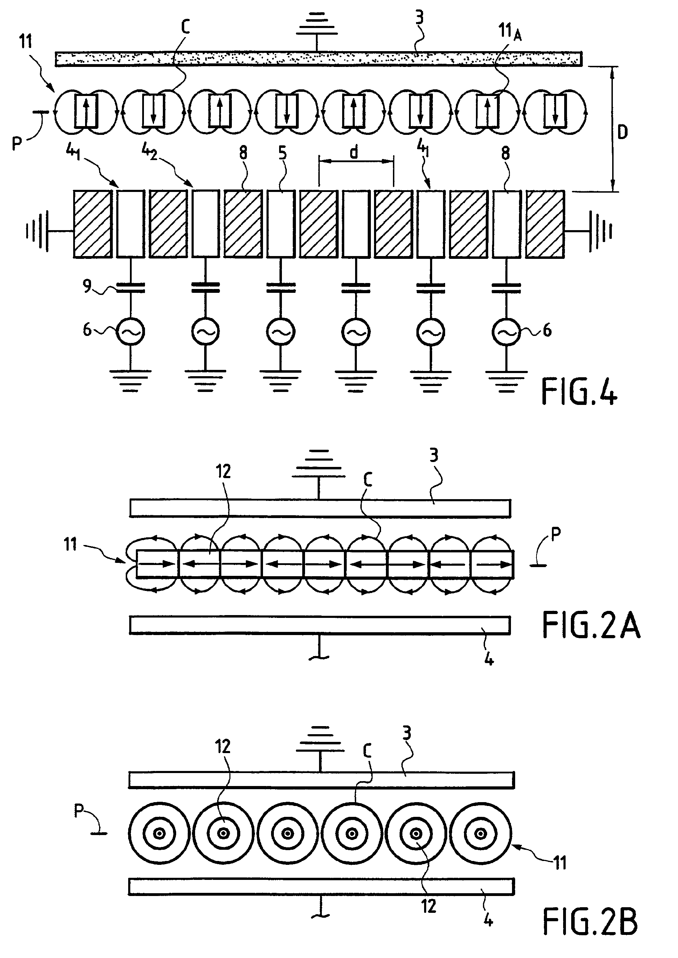

Les **fig. 2A, 2B** illustrent une autre variante de réalisation de la barrière multipolaire **11** constituée à partir de barres d'aimants **12** placées à proximité les unes des autres selon le plan **P** et en étant chacune constituée par une série d'aimants accolés, de manière que leurs axes d'aimantation s'étendent dans le plan **P**, en étant alternés d'un aimant voisin à un autre.

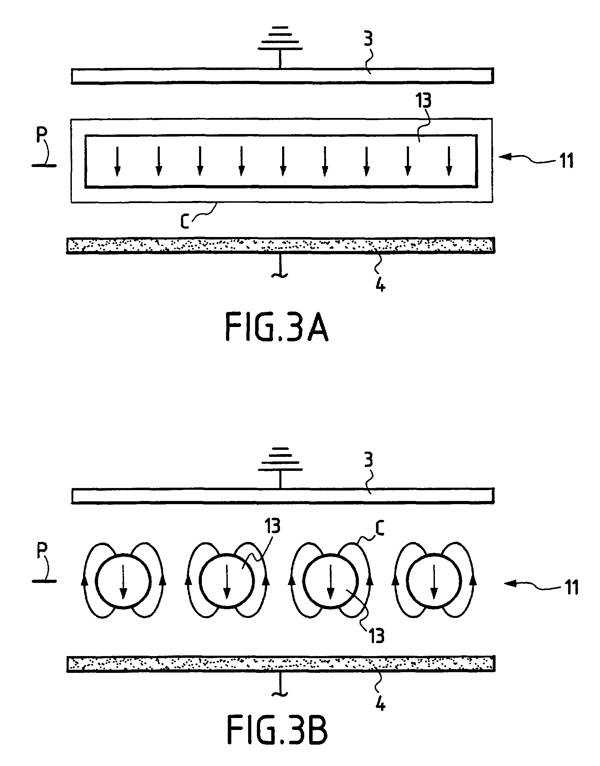

Les **fig. 3A, 3B** illustrent une autre variante de réalisation de la barrière multipolaire **11** constituée à partir de barres d'aimants **13** placées à proximité les unes des autres selon le plan **P** et en étant chacune constituée par un aimant dont l'axe d'aimantation s'étend perpendiculairement au plan **P**. Une telle structure linéaire de l'aimantation selon l'une des dimensions de l'enceinte, favorise l'uniformisation du plasma dans le cas où le rapport des surfaces actives **5** sur les surfaces actives **5** additionnées aux surfaces passives **8** est faible.

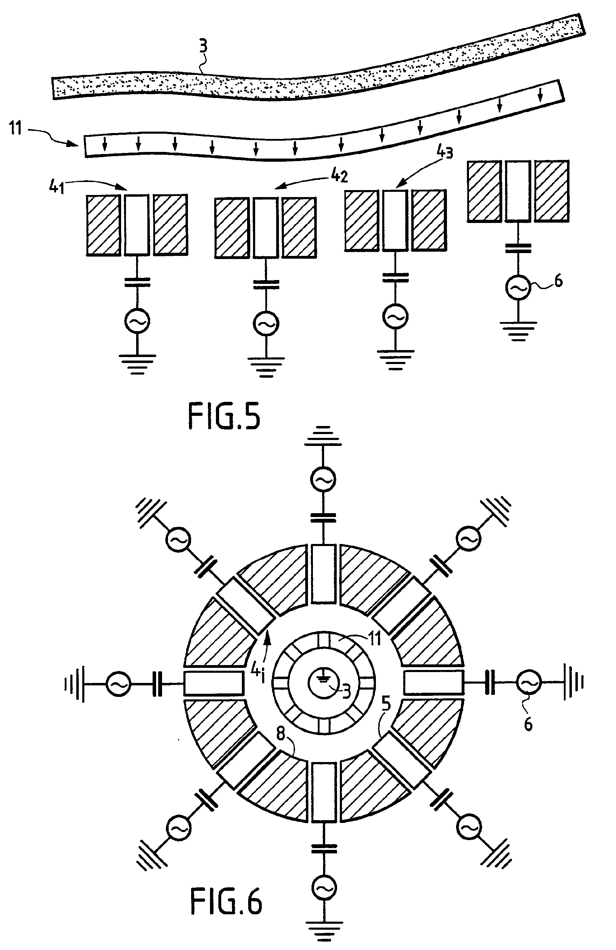

Conformément à une autre caractéristique de l'invention illustrée à la fig. **4**, l'électrode active **4** est constituée par une série d'électrodes actives élémentaires **4**_{**1**}**, 4**_{**2**}**, 4**_{**3**}**, ..., 4**_{**i**} réparties de façon géométriquement uniforme en regard de l'électrode passive **3**. Chaque électrode active élémentaire **4**_{**i**} délimite chacune, en regard de l'électrode passive **3**, d'une part, une surface active **5** alimentée par une source **6** de production d'une tension de maintien de la décharge et, d'autre part, une surface passive **8** placée à un potentiel électrique donné, par exemple de référence, tel que la masse dans l'exemple illustré. Chaque source de production **6** est soit une source de production continue négative, soit comme illustré à la fig. **4**, une source de production d'une tension alternative basse fréquence ou radiofréquence appliquée à travers un condensateur **9**.

Compte tenu de la répartition uniforme des électrodes actives élémentaires **4**_{**i**}, les surfaces actives **5** des électrodes présentent, de préférence, les mêmes dimensions surfaciques, tandis que les surfaces passives **8** des électrodes actives élémentaires **4**_{**i**} présentent également, de préférence, les mêmes dimensions surfaciques. Par ailleurs, la tension de décharge fournie par les sources **6** est appliquée de façon répartie uniquement sur un faible pourcentage de la surface de l'électrode active **4**, à savoir les surfaces actives **5**, tandis que l'autre partie de la surface de l'électrode active (les surfaces passives **8**) est maintenue au potentiel de référence. Il doit être compris que les surfaces actives **5** de l'électrode active sont petites par rapport à la surface de l'électrode passive **3**, de sorte qu'il apparaît une polarisation moyenne négative importante de l'électrode active **4** par rapport au potentiel plasma. Une telle situation, qui correspond au taux d'émission des électrons rapides le plus élevé et à une accélération plus importante des électrons dans la gaine ionique, est donc la plus favorable pour obtenir le claquage du plasma au regard de chaque surface active **5**. Naturellement, plus la surface relative des surfaces actives **5** par rapport à la surface totale de l'électrode **4** est faible, plus la densité de puissance par unité de surface nécessaire au claquage, puis au maintien du plasma, est faible.

Selon une caractéristique avantageuse de l'invention, chaque électrode active élémentaire **4**_{**i**} est alimentée par une source de tension **6** à caractère réglable permettant d'ajuster la puissance sur chacune des électrodes actives élémentaires **4**_{**i**}, de manière à contrôler le niveau de la densité de puissance du maintien du plasma. Chaque électrode active élémentaire **4**_{**i**} peut être alimentée par une tension de maintien de décharge présentant une valeur déterminée identique ou différente, en vue d'obtenir un plasma uniforme. Bien entendu, les électrodes élémentaires actives **4**_{**i**} peuvent être alimentées en puissance électrique, soit par des sources indépendantes (transistors), soit à partir d'une source unique suivie du circuit d'ajustement et de distribution de la puissance. Selon une autre caractéristique de l'invention, la distance **d** entre deux électrodes actives élémentaires **4**_{**i**} voisines est choisie de manière qu'elle soit inférieure ou égale à la distance **D** considérée entre l'électrode passive **3** et l'électrode active **4**. Il peut ainsi être obtenu une uniformité de plasma relativement convenable

L'objet de l'invention présente l'avantage de pouvoir traiter des surfaces planes placées face aux électrodes actives mais aussi des surfaces non planes, par exemple gauches (**fig. 5**) ou cylindriques, comme illustré à la **fig. 6**. Dans ce dernier exemple, les électrodes actives élémentaires **4**_{**i**} sont réparties selon une circonférence à l'intérieur de laquelle est placée à distance une électrode passive **3** de section circulaire.

Les électrodes actives élémentaires **4**_{**i**} comportent des surfaces actives **5** conductrices (métal, semi-conducteur), mais peuvent être recouvertes d'une couche mince diélectrique, dans le cas de l'application d'une tension périodique (décharge radiofréquence). Les électrodes actives élémentaires **4**_{**i**} comportent une surface passive **8** constituée généralement par un blindage métallique porté à un potentiel électrique donné, par exemple de référence tel que la masse. Les surfaces passives **8** des électrodes actives **4**_{**i**} peuvent aussi être isolées par un écran diélectrique ou une couche diélectrique épaisse. Les électrodes actives **4**_{**i**} peuvent aussi être refroidies si nécessaire.

La distribution de puissance sur un ensemble d'électrodes élémentaires **4**_{**i**} permet, d'une part, d'abaisser le niveau de puissance nécessaire à l'allumage du plasma à des valeurs très basses et, d'autre part, d'ajuster l'uniformité du plasma de manière contrôlée, ou encore de pouvoir traiter des surfaces non planes (cylindriques), voire des surfaces gauches. De plus, la barrière multipolaire **11** à pistes magnétron présente deux avantages décisifs qui sont, d'une part, la possibilité d'avoir une polarisation indépendante du substrat et, d'autre part, d'augmenter significativement la densité du plasma, à densité de puissance par unité de surface constante.

Tous ces avantages permettent d'envisager des applications plasma qui n'étaient pas jusqu'à présent, possibles avec les décharges capacitives. Outre les pans nouveaux d'applications ainsi ouverts, l'invention permet aussi d'obtenir une fiabilité plus grande, car en appliquant des puissances nominales plus faibles à chaque électrode active, il est possible d'accroître, de façon très importante, la durée de vie des composants du circuit électrique et donc la fiabilité de fonctionnement du plasma. Enfin, l'invention permet l'extension d'échelle des plasmas sans autres limitations que les limitations technologiques (forces de la pression atmosphérique sur l'enceinte, forces magnétiques, etc).

A titre d'exemples de traitements qu'il est possible d'effectuer dans ces réacteurs nouveaux, il est possible de citer les dépôts de polymères (polymères à propriétés fonctionnelles contrôlées, bio-polymères, résines photosensibles etc), les dépôts de silicium amorphe (avec ajustement de la concentration en hydrogène) ou cristallisé, les dépôts d'alliages de silicium (silice, nitrure de silicium, oxynitrures, etc), les opérations de gravure, et plus généralement tous les traitements plasma conventionnels.

Les plasmas objets de l'invention sont bien adaptés au traitement de grandes surfaces planes (de l'ordre du m² ou plus) comme les panneaux de cellules solaires ou les écrans plats, ou des surfaces gauches comme les vitrages par exemple pour véhicules, qui nécessitent de très bonnes uniformités sur de grandes dimensions.

L'invention n'est pas limitée aux exemples décrits et représentés, car diverses modifications peuvent y être apportées sans sortir de son cadre.

## Revendications

1. Procédé de production d'un plasma par décharges de type capacitif, produites entre une électrode active (**4**) et une électrode passive (**3**), l'électrode passive étant placée à un potentiel électrique donné, tandis que l'électrode active est alimentée par une tension de maintien de décharge,
caractérisé en ce qu'il consiste à placer entre les électrodes, une barrière magnétique multipolaire (**11**) dont les lignes de champ magnétique s'étendent de part et d'autre d'un plan de séparation (**P**) parallèle aux électrodes, de manière à assurer l'oscillation, entre les pôles, des électrons rapides accélérés par l'électrode active, en vue de créer des zones de production et de diffusion de plasma situées de part et d'autre de la barrière magnétique en relation de chaque électrode.

2. Procédé selon la revendication 1, caractérisé en ce qu'il consiste à polariser l'électrode passive (**3**) par une tension d'alimentation, de manière à permettre d'assurer la polarisation de l'électrode passive de façon indépendante par rapport à la production de plasma.

3. Procédé selon la revendication 1 ou 2, caractérisé en ce qu'il consiste :
- à réaliser l'électrode active (**4**) par une série d'électrodes actives élémentaires (**4**_{**i**}) délimitant chacune en regard de l'électrode passive, d'une part, une surface active (**5**) et, d'autre part, une surface passive (**8**),
- à répartir les électrodes actives élémentaires de façon géométriquement uniforme en regard de l'électrode passive, en vue d'obtenir un plasma uniforme,
- et à alimenter les surfaces actives (**8**) des électrodes actives élémentaires par une tension de maintien de décharge.

4. Procédé selon la revendication 3, caractérisé en ce qu'il consiste à déterminer le rapport entre les surfaces actives (**5**) et les surfaces passives (**8**) des électrodes actives élémentaires (**4**_{**i**}), de manière à contrôler le niveau de la densité de puissance du maintien du plasma.

5. Procédé selon la revendication 3 ou 4, caractérisé en ce qu'il consiste à déterminer la distance (**d**) entre deux électrodes actives élémentaires voisines, de manière qu'elle soit inférieure ou égale à la distance (**D**) entre l'électrode passive et l'électrode active.

6. Procédé selon la revendication 3, caractérisé en ce qu'il consiste à alimenter chacune des électrodes actives élémentaires (**4**_{**i**}) par une tension de maintien de décharge présentant une valeur déterminée identique ou différente, en vue d'obtenir un plasma uniforme.

7. Dispositif de production d'un plasma par décharges de type capacitif, pour la mise en oeuvre du procédé conforme à la revendication 1, du type comprenant une électrode passive (**3**) placée à distance d'une électrode active (**4**) alimentée par une tension de maintien de décharge,
caractérisé en ce qu'il comporte, entre les électrodes active (**4**) et passive (**3**), une barrière magnétique multipolaire (**11**) dont les lignes de champ magnétique s'étendent de part et d'autre d'un plan de séparation (**P**) parallèle aux électrodes, de manière à assurer l'oscillation, entre les pôles, des électrons rapides issus de l'électrode active, en vue de créer des zones de production et de diffusion de plasma situées de part et d'autre de la barrière magnétique en relation de chaque électrode.

8. Dispositif selon la revendication 7, caractérisé en ce qu'il comporte une source de polarisation de l'électrode passive, de manière à assurer sa polarisation de façon indépendante par rapport à la production de plasma.

9. Dispositif selon la revendication 6 ou 7, caractérisé en ce qu'il comprend une électrode active constituée par une série d'électrodes actives élémentaires (**4**_{**i**}) réparties de façon géométriquement uniforme en regard de l'électrode passive (**3**), chaque électrode active élémentaire délimitant chacune en regard de l'électrode passive, d'une part, une surface active (**5**) alimentée par une tension de maintien de décharge et, d'autre part, une surface passive (**8**).

10. Dispositif selon la revendication 8, caractérisé en ce qu'il comprend pour chaque électrode active élémentaire (**4**_{**i**}), une source de tension réglable.

11. Dispositif selon la revendication 8, caractérisé en ce qu'il comprend une électrode active (**4**), présentant un profil courbe, plan ou fermé.
